# EUROPEAN PATENT SPECIFICATION

(11) **EP 0 314 211 B1**
(45) Date of publication and mention of the grant of the patent: **19.05.1993**
(21) Application number: 88202200.7
(22) Date of filing: 04.10.1988
(51) Int. Cl.: G02F 1/133, H01L 29/48

(54) **Display device including lateral schottky diodes**
Wiedergabeanordnung mit lateralen Schottky-Dioden
Dispositif de visualisation muni de diodes Schottky latérales

(30) Priority: 19.10.1987 NL 8702490
(43) Date of publication of application: 03.05.1989
(73) Proprietor: Philips Electronics N.V., 5621 BA Eindhoven (NL)
(72) Inventor: Martens, Jan Willem Dirk, NL-5656 AA Eindhoven (NL); Kuijk, Karel Elbert, NL-5656 AA Eindhoven (NL)
(74) Representative: Raap, Adriaan Yde

(56) References cited:
- EP-A- 0 200 599
- EP-A- 0 217 466
- EP-A- 0 260 673
- FR-A- 2 518 788
- FR-A- 2 540 290
- FR-A- 2 548 450
- PATENT ABSTRACTS OF JAPAN, vol. 10, no. 309 (E-447)[2365], 21st October 1986; & JP-A-61 121 469

## Description

The invention relates to a display device comprising:
a display cell having first and second supporting plates arranged substantially parallel and opposite to each other and an electro-optical display material interposed between said first and second supporting plates;
on the inward facing surface of said first supporting plate a matrix of picture electrodes, a plurality of strip-shaped column electodes, and switching elements including at least one Schottky diode, wherein each of said column electrodes is associated with a column of said picture electrodes and wherein each picture electrode is connected via a corresponding switching element to its column electrode, the connection between the picture electrode and switching element is an electrically conductive electrode;
on the inward facing surface of said second supporting plate a row electrode structure.

A display device of this type is suitable for display alphanumerical and video information by means of passive electro-optical display media such as liquid crystals, electrophoretic suspensions and electrochromic materials.

It is known that the number of rows to be driven in displays is increased by providing an extra switch for each picture element. This switch provides for a sufficient treshold with respect to the applied voltage and it ensures that the information presented to a driven row electrode remains available across a picture element during the period when the other row electrodes are driven. The switch also prevents a picture element from undergoing an effective voltage during the period when it is not driven.

A display device of the type mentioned in the opening paragraph is described in British Patent Specification GB 2,129,183 A. This Specification describes the use of Schottky diodes as switches; they have various advantages over semiconductor pn diodes, such as a higher current density, more rapid switching times and smaller crosstalk, which results in a high resolution of the display device. The Schottky diodes referred to in this Specification have a vertical structure comprising a layer of amorphous silicon between two metal layers constituting a Schottky contact (anode) and an ohmic contact (cathode), respectively, with the silicon layer which is highly doped on one side for the purpose of the ohmic contact.
A drawback of such a Schottky diode is that the layer of amorphous silicon has a high resistivity. This resistivity cannot be decreased by doping the semiconductor material because the cathode contact then no longer functions as a Schottky contact. Moreover, a second drawback is not obviated at all; in fact, so-called "pin holes" which may be filled up when providing a metal and may thus cause short circuits between cathode and anode are usually present in the layer of amorphous silicon. This risk will be considerably grater if the semiconductor layer is made thinner in order to decrease the resistance between cathode and anode.

Other drawbacks are that such diodes cover a relatively large surface area due to alignment tolerances. Consequently, they have a high capacitance which increases to crosstalk to a considerable extent. Leakage currents also often occur along the periphery, which necessitates an additional passivation step.

It is a object of the invention to obviate the above-mentioned drawbacks to a substantial extent by providing a different structure of the Schottky diode which can also be manufactured in a simpler manner.

The invention is based on recognition that the influence of possible "pin holes" is substantially negligible if they are substantially perpendicular to a current direction.

A display device according to the invention is therefore characterized in that
the semiconductor layer of the Schottky diode is disposed on the inward facing surface of said first substrate between its corresponding picture electrode and column electrode;
the column electrode touches a lateral side of the semiconductor layer and partly overlaps the semiconductor layer forming a Schottky contact; and
said metal electrode touches the lateral side of the semiconductor layer opposite said lateral side forming the Schottky contact and partly overlies a n⁺ region of said semiconductor layer forming an ohmic contact.

The Schottky diode is preferably realised in a single layer of semiconductor material.

In such a structure the said short circuits between anode and catode contacts due to "pin holes" being filled up can no longer occur. Moreover, much smaller Schottky diodes can be manufactured so that the influence of the diode capacitance and hence the crosstalk is smaller. The distance between anode and cathode may be chosen to be, for example, smaller dan 1 µm. The layer thickness of the semiconductor material may also be chosen to be very small (for example, smaller than 1 µm), which is notably favourable for display devices in which the liquid crystal layer has a small thickness.

The diodes thus obtained can be used in various types of switching units such as, for example, a circuit of two diodes constituting a so-called diode ring.

A method of manufacturing a supporting plate for a display device according to the invention comprises the steps ;
i) a supporting plate is coated with a layer of electrode material;
ii) a matrix of picture electrodes is formed by a lithographic etching proces;
iii) a layer of semiconductor material is deposited;
iv) a plurality of semiconductor elements is formed by a photolithographic process;
v) a metal which constitutes a Schottky barrier with the semiconductor material is deposited;
vi) a pattern of Schottky contacts which at least partly overlap the semiconductor elements and touch lateral sides of the semiconductor elements is formed out of said metal by a photolithographic step;
vii) the metal is provided with an insulation layer at least at the lateral sides of the Schottky contacts;
viii) n⁺-regions are provided in the semiconductor elements using the insulated Schottky contacts as a mask, the n⁺-regions being laterally offset with respect to the Schottky contacts;
ix) the n⁺-regions are connected to the picture electrodes via electrically conductive electrodes.

In this respect is is noted that method steps i) - iv) are known per se from EP-A-0.200.599. However in the method described in said document the semiconductor elements have a two-layer structure viz. a n⁺ amorphous layer and a non-doped layer on which a metal is deposited to obtain Schottky contacts.

The resulting Schottky diodes have a vertical structure, the disadvantages of which have been described above. For the conducting contact the semiconductor body may be doped with impurities, for example, by means of ion implantation.

The invention will now be described in greater detail by way of example with reference to the accompanying drawings in which
Fig. 1 is a diagrammatic plan view of part of a display device according to the invention;
Fig. 2 is a diagrammatic cross-section taken on the line II-II in Fig. 1,
Fig. 3 shows diagrammatically some manufacturing steps for manufacturing a device as shown in Fig. 1.
Fig. 4 shows the associated substitution diagram for one picture element,
Fig. 5 is a diagrammatic plan view of another display device according to the invention,
Fig. 6 is a diagrammatic cross-sectional view of several steps of manufacturing this device,
Fig. 7 shows its substitution diagram, and
Fig. 8 shows substitution diagrams of several other modifications.

The Figures are diagrammatic and not to scale. Corresponding elements are generally denoted by the same reference numerals.

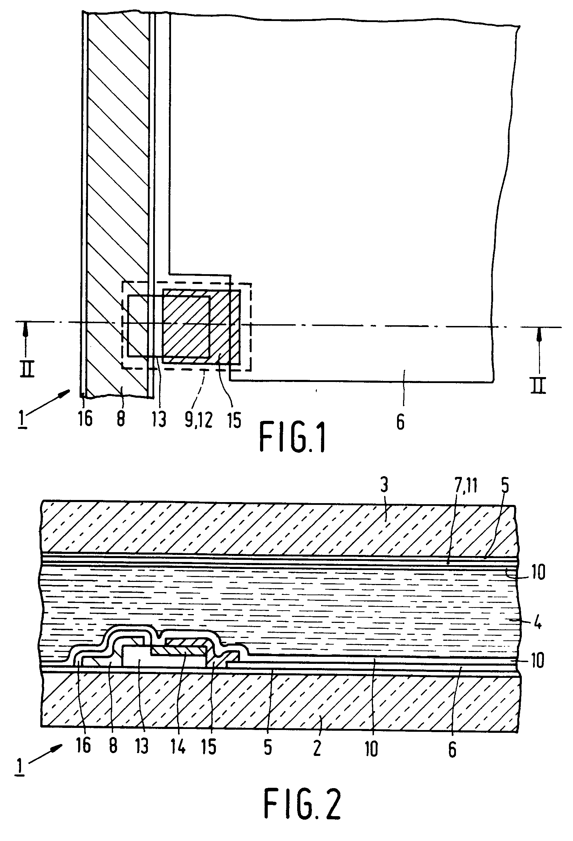

Figs. 1 and 2 show in a plan view and in a cross-section, respectively, a part of a display device 1 comprising two supporting plates 2 and 3 between which a liquid crystal 4 is present. In this example the inner surface of the supporting plates 2 and 3 have electrically and chemically insulating layers 5. A large number of picture electrodes 6 and picture electrodes 7 arranged in rows and columns respectively, are provided on the supporting plates 2 and 3. The facing picture electrodes 6 and 7 constitute the picture elements of the display device. Advantageously, the picture electrodes 7 may be integrated to form strip-shaped row electrodes 11. Strip-shaped column electrodes 8 are provided between the rows of picture electrodes 6. Each picture electrode 6 is connected to a column electrode 8 by means of a switching element 9 shown diagrammatically in Fig. 1, in this example a Schottky diode. The switching elements 9 provide the liquid crystal 4 with a sufficiently steep transition characteristic with respect to the applied voltage and provide the liquid crystal 4 with a memory. Liquid crystal orienting layers 10 are provided on the inner surfaces of the supporting plates 2 and 3. As is known, a different orientation state of the liquid crystal molecules and hence an optically different state can be obtained by applying a voltage across the liquid crystal layer 4. The display device may be realised as a transmissive or reflective device and it may be provided with colour filters.

According to the invention the switching element in this example comprises a lateral Schottky diode 12 formed from a layer 13 of semiconductor material, in this example a layer of amorphous silicon having a thickness of approximately 0.5 µm. For the Schottky barrier this amorphous silicon layer is undoped, which in practice implies a light n-type doping (< 10¹⁸ atoms/cm³) . The column electrode 8 is made of tantalum or another metal which constitutes a Schottky barrier with the amorphous silicon such as, for example, molybdenum or chromium.

For the cathode contact the layer of amorphous silicon has an n⁺ region 14 (contact zone) having a high impurity concentration (approximately 10²¹ atoms/cm³). In this case a conducting contact is realised via a layer 15 of, for example, molybdenum or another suitable metal connecting the diode to the picture electrode 6.

The surface of the Schottky metal is provided with a thin layer 16 of an insulating material, in this case tantalum oxide which determines the distance between the Schottky contact and the contact zone 14, or in other words between anode and cathode of the Schottky diode 12, along the surface of the semiconductor layer 13. This distance is approximately 0.5 µm.

The advantage of such a construction is that the current direction is now substantially perpendicular to the longitudinal axis of possible "pin holes". Moreover, smaller diodes can be realised so that the capacitance effects are smaller and thus greater speeds can be achieved.

Since anode and cathode contacts are no longer arranged on top of each other, a short circuit cannot arise due to possible "pin holes" being filled up. The above-mentioned passivation step is no longer necessary either. In addition the manufacture is also found to be advantageous because no critical masking steps are required.

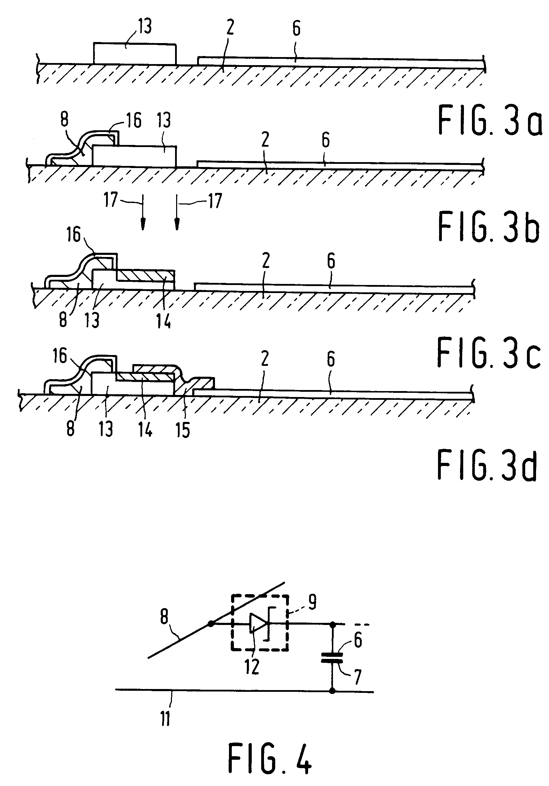

The manufacture will now be described with reference to Fig. 3.

A supporting plate 2 is coated with a layer of electrode material, for example, (translucent) indium tin oxide which is subsequently patterned by means of a photolithographic etching process so that electrodes 6 are formed. Similarly, semiconductor regions 13 of, for example, amorphous silicon are realised (Fig. 3a) on the supporting plate 2.

Subsequently, tantalum or another suitable material is deposited and patterned by way of a photolithographic process. Column electrodes 8 are then formed which partly cover the semiconductor regions 13 and constitute Schottky contacts in situ. These electrodes 8 are then provided with a layer of insulating material 16; in the relevant example the electrodes 8 are provided with a layer of tantalum oxide having a thickness of approximately 0.5µm by means of anodisation (Fig. 3b). Anodising is effected in, for example, a bath containing citric acid, whilst a voltage is applied to the electrodes 8. For this purpose, for example, their ends may be interconnected temporarily.

The parts of the semiconductor regions 13 not covered by tantalum or tantalum oxide are subsequently subjected to an ion implantation, denoted by arrows 17 in Fig. 3c, for example, by means of phosphor ions having an energy of 30 keV and an implantation dose of 10¹⁶ atoms/cm², whereafter an annealing step at approxmimately 200°C takes place. The contact zones 14 are then produced.

In a subsequent step the electrodes 6 and the Schottky diodes are interconnected. To this end the device is coated with one or more layers of a conducting material, for example, molybdenum and/or aluminium from which the metal tracks 15 are formed by way of a photolithographic etching process.

This results in the device of Fig. 3d.

The picture display device is completed by conventionally arranging a second supporting plate 3 provided with column electrodes 7, 11 opposite the supporting plate 2 and by sealing the periphery of the device, whereafter the device is filled with liquid crystal material 7 via an inlet opening in the seal.

The electrical equivalent of a single picture element and the associated switching element 9 consisting of one Schottky diode 12 in this example is shown in Fig. 4.

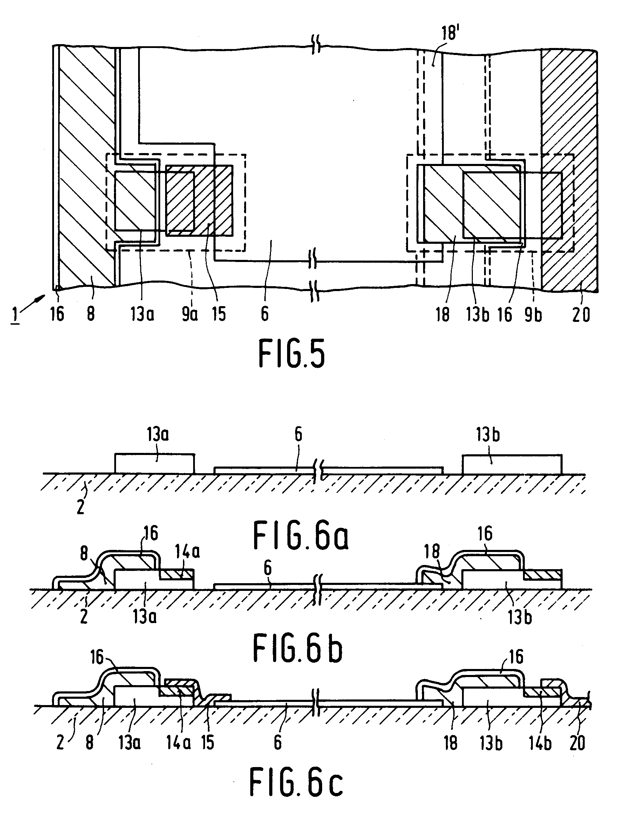

The switching units 9a, 9b in the partial device according to Figs. 5 and 6 are manufactured in a substantially analogous manner. Since the tantalum layer 18 is not accessible via a column electrode in the ultimate configuration, an auxiliary electrode 18′ is temporarily provided for the purpose of anodisation , which electrode is removed by means of a coarse auxiliary mask after anodisation.

The second column electrode 20 can now be provided simultaneously with metal tracks 15. The other reference numerals have the same meaning as those in Figs. 2 and 3.

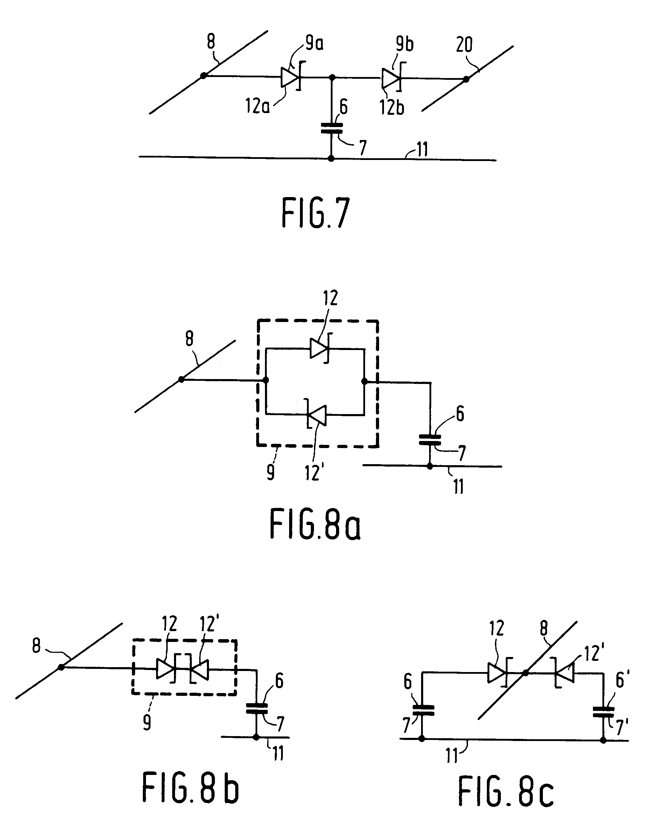

The circuit thus obtained for display devices, a substitution diagram of which is shown in Fig. 7, is described in Netherlands Patent Application no. 8502663 in the name of the Applicant. The column electrode 20 may also be used, for example, for presenting a reference voltage.

The invention is of course not limited to the embodiments shown. Other switching units can be realised such as, for example, diode rings (Fig. 8a) or the switching units shown in Fig. 8b. Metal parts to be anodised are not always connected to a common conductor. For the anodisation step an auxiliary electrode may be provided temporarily, which electrode is removed after anodisation.

In some cases this auxiliary electrode may form part of the ultimate tantalum configuration; in Fig. 5 this can be achieved, for example, by choosing the auxiliary electrode 18′ to be so narrow that the translucent properties of the picture electrodes 6 are not affected.

The semiconductor regions 13 need not be manufactured of one material, but if necessary an intermediate layer of a semiconductor material may be provided between the substrate and the actual Schottky diode. The manufacturing method may also be performed in accordance with several variations. For example, the ohmic contact of the Schottky diode may also be obtained by providing a structured layer of n⁺ monocrystalline silicon by means of photolithographic techniques, which layer covers the amorphous silicon at the location of the contact.

## Claims

1. A display device comprising:
a display cell (1) having first and second supporting plates (2, 3) arranged substantially parallel and opposite to each other and a electro-optical display material interposed between said first and second supporting plates;
on the inward facing surface of said first supporting plate (2) a matrix of picture electrodes (6), a plurality of strip-shaped column electrodes (8), and switching elements (9) including at least one Schottky diode (12), wherein each of said column electrodes (8) is associated with a column of said picture electrodes and wherein each picture electrode (6) is connected via a corresponding switching element (9) to its column electrode, the connection between the picture electrode and switching element is via a metal electrode (15);
on the inward facing surface of said second supporting plate (2) a row electrode structure (7)
characterized in that
the semiconductor layer (13) of the Schottky diode (12) is disposed on the inward facing surface of said first substrate between its corresponding picture electrode (6) and column electrode (8);
the column electrode (8) touches a lateral side of the semiconductor layer and partly overlaps the semiconductor layer forming a Schottky contact; and
said metal electrode (15) touches the lateral side of the semiconductor layer (13) opposite said lateral side forming the Schottky contact and partly overlies a n⁺ region of said semiconductor layer (13) to form an ohmic contact.

2. A display device as claimed in Claim 1, characterized in that the layer of semiconductor material has a thickness of at most 1 µm.

3. A display device as claimed in Claim 1 or 2, characterized in that the distance between the cathode contact and the anode contact of the Schottky diode is at most 1 µm.

4. A display device as claimed in any one of Claims 1 to 3, characterized in that the picture electrode is connected to a second column electrode via a further Schottky diode.

5. A display device as claimed in any one of Claims 1 to 3, characterized in that the switching element comprises at least a parallel circuit of two Schottky diodes biased in different directions.

6. A display device as claimed in any one of Claims 1 to 5, characterized in that the semiconductor material is amorphous silicon.

7. A display device as claimed in Claim 6, characterized in that the Schottky contact of the Schottky diode is constituted by means of one the metal tantalum, aluminium, molybdenum and chromium.

8. A display device as claimed in any one of the preceding Claims, characterized in that the electro-optical display medium is a liquid crystal, an electrophoretic suspension or an electrochromic material.

9. A method of manufacturing a supporting plate for a display device comprising the steps :
i) a supporting plate (2) is coated with a layer of electrode material;
ii) a matrix of picture electrodes (6) is formed by a lithographic etching process;
iii) a layer of semiconductor material is deposited;
iv) a plurality of semiconductor elements (13) is formed by a photolithographic process;
v) a metal which constitutes a Schottky barrier with the semiconductor material is deposited;
vi) a pattern of Schottky contacts which at least partly overlap the semiconductor elements and touch lateral sides of the semiconductor elements is formed out of said metal by a photolithographic process;
vii) the metal is provided with an insulation layer (16) at least at the lateral sides of the Schottky contacts;
viii) n⁺ regions (14) are provided in the semiconductor elements using the insulated Schottky contacts as a mask, the n⁺-regions being laterally offset with respect to the Schottky contacts;
ix) the n⁺ regions (14) are connected to the picture electrodes via electrically conductive electrodes (15);

10. The method of Claim 9 characterized in that the insulation layer (16) is provided by means of anodising.

## Patentansprüche

1. Wiedergabeanordnung mit einer Wiedergabezelle (1), die erste und zweite Trägerplatten (2, 3) enthält, die im wesentlichen parallel zueinander verlaufen und einander gegenüberliegen, und ein elektrooptisches Wiedergabematerial zwischen den ersten und zweiten Trägerplatten enthält, mit einer Matrix von Bildelektroden (6) an der der Innenseite zugewandten Oberfläche der ersten Trägerplatte )2), mit einer Anzahl streifenförmiger Spaltenelektroden (8) und mit Schaltelementen (9) mit wenigstens einer Schottky-Diode (12), wobei jede der Spaltenelektroden (8) einer Spalte der Bildelektroden zugeordnet ist und jede Bildelektrode (6) über ein entsprechendes Schaltelement (9) mit ihrer Spaltenelektrode verbunden ist, und die Verbindung zwischen der Bildelektrode und dem Schaltelement eine Metallelektrode ist, mit einer Zeilenelektrodenstruktur (7) an der der Innenseite zugewandten Oberfläche der zweiten Trägerplatte (2), dadurch gekennzeichnet, daß die Halbleiterschicht (13) der Schottky-Diode (12) an der der Innenseite zugewandten Oberfläche des ersten Substrats zwischen ihrer entsprechenden Bildelektrode (6) und der Spaltenelektrode (8) angeordnet ist, die Spaltenelektrode (8) eine Lateralseite der Halbleiterschicht kontaktiert und teilweise die Halbleiterschicht zur Bildung eines Schottky-Kontakts überlappt, und die Metallelektrode (15) die laterale Seite der Halbleiterschicht (13) gegenüber der Lateralseite zur Bildung des Schottky-Kontakts kontaktiert und teilweise einen n⁺ Gebiet der Halbleiterschicht (13) zur Bildung eines ohmschen Kontakts bedeckt.

2. Wiedergabeanordnung nach Anspruch 1, dadurch gekennzeichnet, daß die Schicht aus Halbleitermaterial eine Dicke von höchstens 1 µm besitzt.

3. Wiedergabeanordnung nach Anspruch 1 oder 2, dadurch gekennzeichnet, daß der Abstand zwischen dem Kathodenkontakt und dem Anodenkontakt der Schottky-Diode höchstens 1 µm beträgt.

4. Wiedergabeanordnung nach einem der Ansprüche 1 bis 3, dadurch gekennzeichnet, daß die Bildelektrode über eine weitere Schottky-Diode mit einer zweiten Spaltenelektrode verbunden ist.

5. Wiedergabeanordnung nach einem der Ansprüche 1 bis 3, dadurch gekennzeichnet, daß das Schaltelement wenigstens eine Parallelschaltung zweier in verschiedenen Richtungen vorgespannter Schottky-Dioden enthält.

6. Wiedergabeanordnung nach einem der Ansprüche 1 bis 5, dadurch gekennzeichnet, daß das Halbleitermaterial amorphes Silizium ist.

7. Wiedergabeanordnung nach Anspruch 6, dadurch gekennzeichnet, daß der Schottky-Kontakt der Schottky-Diode aus einem der Metalle Tantal, Aluminium, Molybdän und Chrom zusammengesetzt ist.

8. Wiedergabeanordnung nach einem oder mehreren der vorangehenden Ansprüche, dadurch gekennzeichnet, daß das elektrooptische Wiedergabemedium ein Flüssigkristall, eine elektrophoretische Lösung oder ein elektrochromes Material ist.

9. Verfahren zum Herstellen einer Trägerplatte für eine Wiedergabeanordnung nach der Erfindung mit folgenden Schritten:
i) eine Trägerplatte (2) wird mit einer Elektrodenmaterialschicht bedeckt,
ii) eine Bildelektrodenmatrix (6) wird mit einem lithographischen Ätzverfahren gebildet,
iii) es wird eine Halbleitermaterialschicht niedergeschlagen,
iv) eine Anzahl von Halbleiterelementen (13) wird mit einem photolithographischen Verfahren gebildet,
v) ein Metall, das eine Schottky-Barriere mit dem Halbleitermaterial bildet, wird niedergeschlagen,
vi) ein Muster von Schottky-Kontakten, die wenigstens teilweise die Halbleiterelemente überlappen und laterale Seiten der Halbleiterelemente kontaktieren, wird aus dem Metall in einem photolithographischen Schritt gebildet,
vii) das Metall wird mit einer Isolierschicht wenigstens an der lateralen Seite der Schottky-Kontakte angebracht,
viii) n⁺-Gebiete (14) werden unter Verwendung der isolierten Schottky-Kontakte als Maske in den Halbleiterelementen angebracht, wobei die n⁺-Gebiete gegen die Schottky-Kontakte lateral versetzt werden,
ix) die n⁺-Gebiete (14) werden über elektrisch leitende Elektroden (15) mit den Bildelektroden verbunden.

10. Verfahren nach Anspruch 9, dadurch gekennzeichnet, daß die Isolierschicht (16) mittels Anodisierung angebracht wird.

## Revendications

1. Dispositif d'affichage comprenant :
une cellule d'affichage (1) comportant une première et une seconde plaque de support (2, 3) disposées en substance parallèlement et en opposition l'une à l'autre et une matière d'affichage électro-optique intercalée entre la première et la seconde plaque de support;
sur la surface tournée vers l'intérieur de la première plaque de support (2), une matrice d'électrodes d'image (6), une pluralité d'électrodes de colonne en forme de bandes (8) et des éléments de commutation (9) comprenant au moins une diode Schottky (12), dans lequel chacune des électrodes de colonne (8) est associée à une colonne des électrodes d'image et chaque électrode d'image (6) est connectée par un élément de commutation correspondant (9) à son électrode de colonne, la connexion entre l'électrode d'image et l'élément de commutation s'effectuant via une électrode métallique (15);
sur la surface tournée vers l'intérieur de la seconde plaque de support (2), une structure des électrodes de rangée (7)
caractérisé en ce que :
la couche semi-conductrice (13) de la diode Schottky (12) est disposée sur la surface tournée vers l'intérieur du premier substrat, entre son électrode d'image (6) correspondante et son électrode de colonne (8);
l'électrode de colonne (8) touche un côté latéral de la couche semi-conductrice et chevauche partiellement la couche semi-conductrice formant un contact de Schottky; et
l'électrode métallique (15) touche le côté latéral de la couche semi-conductrice (13) opposé au côté latéral formant le contact de Schottky et recouvre partiellement une région n⁺ de la couche semi-conductrice (13) pour former un contact ohmique.

2. Dispositif d'affichage suivant la revendication 1, caractérisé en ce que la couche de matière semi-conductrice a une épaisseur de tout au plus 1 µm.

3. Dispositif d'affichage suivant la revendication 1 ou 2, caractérisé en ce que la distance entre le contact de cathode et le contact d'anode de la diode Schottky est tout au plus de 1 µm.

4. Dispositif d'affichage suivant l'une quelconque des revendications 1 à 3, caractérisé en ce que l'électrode d'image est connectée à une seconde électrode de colonne par l'intermédiaire d'une autre diode Schottky.

5. Dispositif d'affichage suivant l'une quelconque des revendications 1 à 3, caractérisé en ce que l'élément de commutation comprend au moins un circuit parallèle de deux diodes Schottky polarisées dans des directions différentes.

6. Dispositif d'affichage suivant l'une quelconque des revendications 1 à 5, caractérisé en ce que la matière semi-conductrice est du silicium amorphe.

7. Dispositif d'affichage suivant la revendication 6, caractérisé en ce que le contact de Schottky de la diode Schottky est constitué d'un des métaux comprenant le tantale, l'aluminium, le molybdène et le chrome.

8. Dispositif d'affichage suivant l'une quelconque des revendications précédentes, caractérisé en ce que le milieu d'affichage électrooptique est un cristal liquide, une suspension électrophorétique ou une matière électrochromique.

9. Procédé de fabrication d'une plaque de support pour un dispositif d'affichage comprenant les opérations suivantes :
i) une plaque de support (2) est revêtue d'une couche de matière d'électrode;
ii) une matrice d'électrodes d'image (6) est formée par un procédé de gravure lithographique;
iii) une couche de matière semi-conductrice est déposée;
iv) une pluralité d'éléments semi-conducteurs (13) est formée par un procédé photolithographique;
v) un métal qui constitue une barrière de Schottky avec la matière semi-conductrice est déposé;
vi) un motif de contacts de Schottky qui chevauche au moins partiellement les éléments semi-conducteurs et touche les côtés latéraux des éléments semi-conducteurs est formé du métal par une opération photolithographique;
vii) le métal est pourvu d'une couche d'isolation (16) au moins aux côtés latéraux des contacts de Schottky;
viii) des régions n⁺ (14) sont prévues dans les éléments semi-conducteurs en utilisant les contacts de Schottky isolés comme masque, les régions n⁺ étant décalées latéralement par rapport aux contacts de Schottky;
ix) les régions n⁺ (14) sont connectées aux électrodes d'image par l'intermédiaire d'électrodes conductrices de l'électricité (15).

10. Procédé suivant la revendication 9, caractérisé en ce que la couche d'isolation (16) est formée par anodisation.
